**Europäisches Patentamt**

**European Patent Office**

**Office européen des brevets**

(19)

(11) Veröffentlichungsnummer: **0 088 474**
**B1**

(12) # EUROPÄISCHE PATENTSCHRIFT

(45) Veröffentlichungstag der Patentschrift:
**02.11.88**

(51) Int. Cl.⁴: **H 03 H 17/02,** H 03 H 3/00

(21) Anmeldenummer: **83200295.0**

(22) Anmeldetag: **28.02.83**

(54) Verfahren zur Herstellung einer digitalen Filteranordnung als integrierte Schaltung.

(30) Priorität: **06.03.82 DE 3208118**

(43) Veröffentlichungstag der Anmeldung:
**14.09.83 Patentblatt 83/37**

(45) Bekanntmachung des Hinweises auf die Patenterteilung:
**02.11.88 Patentblatt 88/44**

(84) Benannte Vertragsstaaten:
**DE FR GB IT**

(56) Entgegenhaltungen:
**REVIEW OF THE ELECTRICAL COMMUNICATION LABORATORIES, Band 27, Nrn. 1/2, Januar / Februar 1979, Seiten 72-81, Tokyo, JP; N. OHWADA u.a.: "CMOS LSIs for digital signal processing"**
**THE RADIO AND ELECTRONIC ENGINEER, Band 46, Nr. 4, April 1976, Seiten 173-181, London, GB; R. DE MORI: "Cellular structures for implementing recursive and non-recursive digital filters"**
**ELEKTRONIK, Heft 3, 12. Februar 1982, Seiten 73-77, München, DE; W. DEMMER u.a.: "Pipelining-Verfahren in der digitalen Signalverarbeitung"**

(73) Patentinhaber: **Philips Patentverwaltung GmbH, Wendenstrasse 35 Postfach 10 51 49, D-2000 Hamburg 1 (DE)**
(84) Benannte Vertragsstaaten: **DE**

(73) Patentinhaber: **N.V. Philips' Gloeilampenfabrieken, Groenewoudseweg 1, NL- 5621 BA Eindhoven (NL)**
(84) Benannte Vertragsstaaten: **FR GB IT**

(72) Erfinder: **Draheim, Peter, Dr., Goldmariekenweg 32, D-2000 Hamburg 61 (DE)**

(74) Vertreter: **Poddig, Dieter, Dipl.- Ing., Philips Patentverwaltung GmbH Wendenstrasse 35 Postfach 10 51 49, D-2000 Hamburg 1 (DE)**

EP 0 088 474 B1

LIBER, STOCKHOLM 1988

**0 088 474**

**Beschreibung**

Die Erfindung betrifft ein Verfahren zur Herstellung einer digitalen Filteranordnung aus einer Anzahl Verzögerungs schaltungen, einer Anzahl Addierschaltungen und einer Anzahl durch Addierschaltungen realisierte Multiplikationsschaltungen als eine auf einem einzigen Halbleiterplättchen integrierte Schaltungsanordnung, bei dem die Verzögerungsschaltungen und die Addierschaltungen auf dem Halbleiterplättchen vorgesehen werden und nach Festlegung der Filtercharakteristik, insbesondere der Übertragungsfunktion, die einzelnen Verzögerungsschaltungen und Addierschaltungen entsprechend verbunden werden.

Ein solche Verfahren ist aus dem Dokument "REVIEW OF THE ELECTRICAL COMMUNICATION LABORATORIES", Band 27, Nr. 1/2, Januar/Februar 1979; N. Ohwada: "CMOS LSIs for DIGITAL Signal Processing" bekannt ist. In dieser Druckschrift wird die Herstellung einer digitalen Schaltungsanordnung, z. B. für digitale Filter, beschrieben. Diese enthält auf einem einzigen Halbleiterplättchen Multiplikationsschaltungen, Addierschaltungen, Subtrahierschaltungen und Verzögerungsglieder. Die gewünschte Funktion, z. B. die Filtercharakteristik, der digitalen Schaltung wird durch Schalter hergestellt, die von einem Programmierbaren Speicher gesteuert werden. Ein solcher Aufbau mit steuerbaren Schaltern an jeder möglichen Verbindungsstelle ist sehr aufwendig.

Aus der Zeitschrift "Elektronik", Heft 3 (1982), Seiten 73 bis 77, sind ähnliche Filteranordnunge bekannt. Die Grundstruktur digitaler Filteranordnung ist also aus zeitlichen Signalverzögerungsschaltungen und arithmetischen Schaltungen aufgebaut. Das Eingangssignal wird direkt und verzögert über die Signalverzögerungen mittels Registern einer Summation zugeführt, wobei die einzelnen verzögerten Signale über Multiplikation mit Koeffizienten gewichtet werden können. Das Ergebnis aller Signale stellt dann das Ausgangssignal dar.

Die Multiplikation kann auch in eine Anzahl Additionen von jeweils zwei Signalen aufgelöst werden, wobei dann auch eine sogenannte Pipelinestruktur gebildet werden kann wie in der angegebenen Druckschrift dargestellt ist.

Für die Herstellung einer digitalen Filteranordnung als integrierte Schaltungsanordnung werden üblicherweise die benötigten Elemente sowie die erforderlichen Verbindungen untereinander in bekannter Weise auf einem einzigen Halbleiterplättchen integriert. Für eine solche Herstellung sind eine Vielzahl von einzelnen Herstellungsschritten und Masken dafür erforderlich. Wenn die Charakteristik eines vorhandenen Filters geändert werden soll, ist es oft auch notwendig, die Anzahl bzw. die Anordnung der einzelnen Elemente sowie deren Verbindung untereinander zu ändern. Für die integrierte Herstellung eines solchen digitalen Filters ist dann ein vollständig neuer Schaltungsentwurf erforderlich, für den normalerweise alle Masken neu entworfen werden müssen, was einen erheblichen Aufwand darstellt.

Aufgabe der Erfindung ist es, ein Verfahren der eingangs genannten Art anzugeben, nach dem verschiedene digitale Filteranordnungen mit geringem Aufwand und schnell hergestellt werden können.

Diese Aufgabe wird erfindungsgemäß dadurch gelöst, daß eine Anzahl Basiszellen, von denen jede aus einer Addierschaltung und einer Anzahl in einer Reihe damit angeordneten Verzögerungsschaltungen für jeweils ein Bit bestehen, von denen aus sich Verbindungsleiter parallel zueinander etwa senkrecht zur Reihe erstrecken, in Zeilen und Spalten angeordnet sind, wobei die Verzögerungsschaltungen und die Addierschaltungen zunächst ohne Verbindungen untereinander angebracht werden, und daß in einem nachträglichen Herstellungsschritt an den Verbindungsleitern Verbindungspunkte und in Zeilenrichtung verlaufende, die Verbindungsleitungen kreuzende und die Verbindungspunkte berührende Leiterbahnen angebracht werden.

Bei dem erfindungsgemäßen Verfahren ermöglich die Verbindung der Verbindungsleiter in einem nachträglichen Herstellungsschritt eine schnelle, einfache und billige Herstellung Verschiedener Filter, da dieser Schritt teilweise automatisiert werden kann. Weiter ergeben sich aufgrund der übersichtlichen und regelmäßigen Struktur der Basiszellen bzw. der Basiszellen untereinander kurze Verbindungen zwischen den einzelnen Elementen. Daher wird nur eine begrenzte Anzahl von Leiterbahnen benötigt. Dabei wird auch die Tatsache ausgenutzt, daß Multiplikationen durch Additionen ersetzt werden können, so daß praktisch nur zwei Arten von Verschiedenen Elementen bzw. Schaltungen auf dem Halbleiterplättchen vorhanden sein müssen.

Es ergibt sich eine sehr übersichtliche und regelmäßige Struktur, bei der die Verbindungen zwischen den einzelnen Elementen im allgemeinen nur kurz sind und nur eine begrenzte Anzahl von Leiterbahnen benötigt wird. Da jede Basiszelle nur ein Bit verarbeitet, können die einzelnen Bits der mehrstelligen Dualwörter, die dem Filter zugeführt werden, den verschiedenen Zeilen der Anordnung zugeführt werden. Eine Multiplikation mit dem Faktor 2 bzw. 1/2 ergibt dabei eine Verschiebung um eine Bitordnung, d. h. die Information wechselt bei der angegebenen Anordnung von einer Zeile auf die nächste.

Das Herstellen der Verbindungen kann so erfolgen, daß ein Teil der Verbindungen durch ein gesondert angebrachtes Verbindungsmuster und die übrigen Verbindungen durch steuerbare Schalter gebildet werden. Dies ist günstig, da bei der elektrischen Steuerung der Charakteristik des Filters nach Beendigung der Herstellung durch Ansteuerung der steuerbaren Schalter nur einige Verbindungen umgeschaltet werden müssen, während für verschiedene Charakteristiken ein Teil der Verbindungen fest ist. Dadurch ergibt sich dann eine einfachere Ansteuerung.

Für die Ansteuerung der steuerbaren Schalter ist es zweckmäßig, daß Verbindungen zwischen den Steuereingängen der steuerbaren Schalter und einem auf dem Haltleiterplättchen vorhandenen binären Speicher angebracht werden. Dadurch kann über nur wenige Steuereingänge die Charakteristik des Filters mittels einer größeren Anzahl von Schaltern umgeschaltet werden.

Zur Bildung verschiedener umschaltbarer Filter für die Steuereingänge der steurbaren Schalter ebenfalls im nachträglichen Herstellungsschritt angebracht werden. Dadurch ist nur eine Maske für alle Verbindungen, d. h. für die unveränderbaren und die durch steuerbare Schalter veränderbaren Verbindungen, notwendig. Eine andere Möglichkeit besteht darin, daß der Speicher ein Festwertspeicher ist und der Speicherinhalt in dem nachträglichen Herstellungsschritt festgelegt wird. Dabei können die Verbindungen für die Steuereingänge der steuerbaren Schalter bereits vorhanden sein, und um einen Schalter unwirksam zu machen, erhält der Festwertspeicher lediglich einen Inhalt, bei dem der betreffende Schalter nicht angesteuert wird.

Um möglichst viele praktisch vorkommende digitale Filter herstellen zu können, sollte auf dem in den vorhergehenden Herstellungsschritten erzeugten Halbleiterplättchen eine ausreichende Anzahl von Verzögerungs- und Addierschaltungen vorgesehen werden. Außerdem ist es denkbar, wenn die verschiedenen Elemente bzw. Schaltungen in einer bestimmten Anordnung auf dem Halbleiterplättchen vorhanden sind, daß sich für manche Filtercharakterisken schwierig bzw. aufwendig herstellbare Verbindungen bei einzelnen Schaltungen ergeben. In diesem Falle ist es zweckmäßig, daß nur ein Teil der Schaltungen, insbesondere der Verzögerungsschaltungen, mit Verbindungen versehen werden. Dabei bleiben dann ein Teil der Schaltungen unbenutzt, was jedoch herstellungstechnisch nicht nachteilig sein muß, da der Aufwand bzw. die Kosten für die Herstellung einer digitalen Filteranordnung nach dem erfindungsgemäßen Verfahren wesentlich durch den nachträglichen Herstellungsschritt bestimmt werden, während die vorhergehende Herstellung der Elemente auf dem Halbleiterplättchen ohne Verbindungen als Standard-Herstellungsverfahren preiswert ist.

Um die Verlustleistung zu verringern, wenn einzelne Schaltungen nicht mit Verbindungen versehen werden und somit unbenutzt sind, ist es zweckmäßig, daß auch Verbindungen für die Stromversorgung der einzelnen Schaltungen in dem nachträglichen Herstellungsschritt hergestellt werden, wobei für Schaltungen ohne Signalverbindungen auch die Verbindungen für die Stromversorgung weggelassen werden. Dies bedeutet herstellungsmäßig keinen Mehraufwand.

Für einen gedrängten Aufbau, bei dem auch Verbindungen zwischen benachbarten Zeilen gut ausgeführt werden können, ist es zweckmäßig, daß in benachbarten, in Richtung der Reihenanordnung in den Basiszellen verlaufenden Zeilen von Basiszellen diese um einen Teil der Länge der Basiszellen gegeneinander verschoben sind.

Eine weitere Ausgestaltung, bei der die Verbindungen innerhalb der Basiszellen sowie auch zu benachbarten Zeilen von Basiszellen günstig, d. h. insbesondere kurz ausgeführt werden können, ist dadurch gekennzeichnet, daß in den Basiszellen die Verbindungsleitungen sich nach beiden Seiten der Schaltungen erstrecken und zwischen den Schaltungen ganze Zeile oder mehrere Zeilen von Basiszellen zu überspringen. Für die Verbindung de Schaltungen zwischen Basiszellen einer Zeile ist es zweckmäßig, daß die Leiterbahnen sich über mehrere Basiszellen einer Zeile erstrecken. Auch dadurch werden kurze Verbindungen errichtet.

Ausführungsbeispiele der Erfindung werden nachstehend anhand der Zeichnung näher erläutert. Es zeigen

Fig. 1  die allegemeine Struktur eines digitalen Transversal-Filters,
Fig. 2  die Abwandlung dieses Filters in einer Pipeline-Struktur
Fig. 3  die allgemeine Anordnung der Verzögerungs- und Addierschaltungen auf einem Halbleiterplättchen mit allgemein angegebenen Verbindungen zur Realisierung digitaler Filterstrukturen,
Fig. 4  den Aufbau von Basiszellen sowie deren gegenseitige Anordnung in verschiedene Zeilen,
Fig. 5  ein spezielles digitales Filter mit vorbestimmter Übertragungsfunktion,
Fig. 6  die Anordnung einer Anzahl Basiszellen mit den Verbindungen untereinander zur Realisierung des Filters nach Fig. 5.

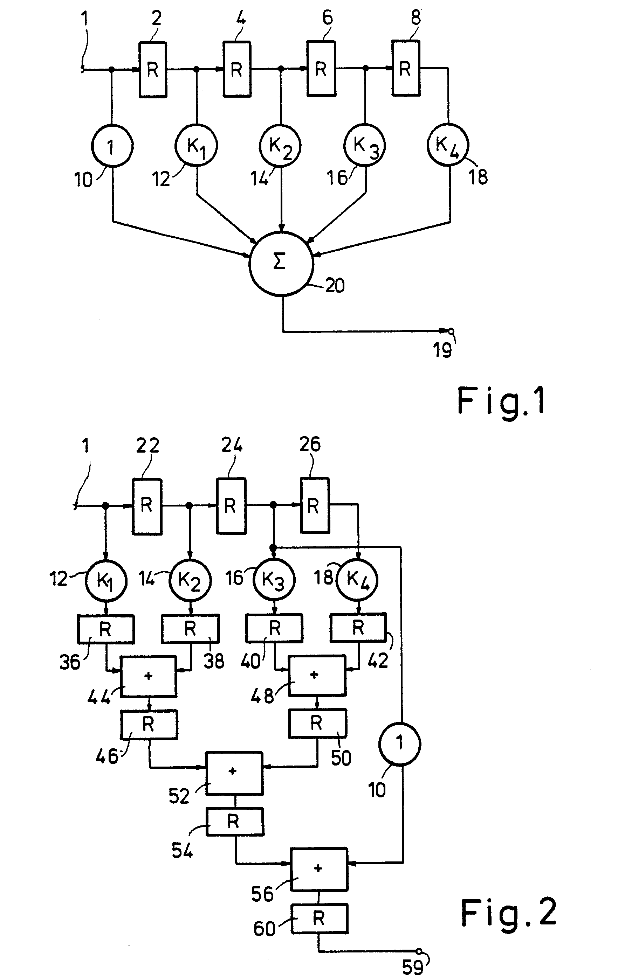

In Fig. 1 werden dem Eingang 1 eine Folge von Dualwörtern zugeführt, die Abtastwerte eines analogen Signals darstellen. Die Dualwörter werden dabei üblicherweise bitparallel zugeführt, so daß die Verbindungen in Fig. 1 tatsächlich aus einer Anzahl paralleler Leitungen bestehen.

Die Dualwörter werden einer Kette von Verzögerungsschaltungen 2, 4, 6 und 8 zugeführt, von denen jede Verzögerungsschaltung aus einem digitalen Register mit mehreren Speicherelementen zur Aufnahme jeweils eines Dualwortes besteht. Alle Verzögerungsschaltungen erhalten gemeinsam von einer nicht dargestellten Taktsignalquelle Schiebetakte, durch die jede Verzögerungsschaltung das an ihrem Eingang anliegende Dualwort übernimmt und am Ausgang zur Verfügung stellt. Die Kette der Verzögerungsschaltungen 2 bis 8 stellt somit ein mehrstufiges Schieberegister für Mehrbit-Dualwörter dar.

Am Eingang bzw. am Ausgang aller Verzögerungsschaltungen sind Multiplizierer 10, 12, 14, 16 und 18 angeschlossen, die die von den entsprechenden Anschlüssen der Verzögerungsschaltungen 2 bis 8 zugeführten Dualwörtern mit einem festen Koeffizientenwert multiplizieren, der in diesen Multiplizierern angegeben ist. In dem hier dargestellten Beispiel realisiert der erste Multiplizierer 10 eine Multiplikation mit dem Faktor 1, d. h. das empfangene Dualwort wird unverändert am Ausgang des Multiplizierers 10 abgegeben. Die übrigen Koeffizienten $k_1$ bis $k_4$ können von 1 verschieden und auch negativ sein.

Die Ausgänge aller Multiplizierer 10 bis 18 führen auf eine Summierschaltung 20, die die Summe aller gleichzeitig zugeführten Dualwörter bildet und am Ausgang 19 abgibt. Die dort abgegebenen Dualwörter stellen die Abtastwerte des gefilterten analogen Signals dar, wobei die Filterung der nachstehenden komplexen Übertragungsfunktion entspricht:

3

$$H(z) = 1 \cdot z^0 + k_1 \cdot z^{-1} + k_2 \cdot z^{-2} + k_3 \cdot z^{-3} + k_4 \cdot z^{-4}$$

Die Übertragungsfunktion wird somit durch die Koeffizienten $k_1$ bis $k_4$ bestimmt, mit denen die Dualwörter in den Multiplizierern 12 bis 18 multipliziert werden, sowie auch durch die Anzahl der Koeffizienten bzw. die Länge der Kette von Verzögerungsschaltungen 2 bis 8. Allgemein bestimmt die Anzahl der Verzögerungsschaltungen die Steilheit der Übertragungsfunktion an der Grenzfrequenz bzw. den Grenzfrequenzen.

Der Summierer 20 in Fig. 1 ist allgemein als Akkumulator aufgebaut, der die zugeführten Ausgangssignale der Multiplizierer nacheinander aufsummiert. Diese aufeinanderfolgende Verarbeitung von Werten beschränkt die maximale Frequenz der Schiebetakte, mit der jeweils ein neues Dualwort am Eingang 1 übernommen werden kann. Zur Erhöhung dieser Frequenz kann die in Fig. 2 dargestellte Pipeline-Struktur des Filters nach Fig. 1 verwendet werden. Darin werden die dem Eingang 1 zugeführten Dualworte in ein Schieberegister aus den Verzögerungsschaltungen 22 bis 26 übernommen, an dessen Eingang und Ausgang sowie zwischen Anschlüssen wieder die Multiplizierer 10 bis 18 angeschlossen sind. Die Ausgänge der Multiplizierer 12 bis 18 führen jedoch jeweils auf ein Register 36 bis 42, von denen jedes ein Dualwort aufnehmen kann. Diese Register 36 bis 42 erhalten den gleichen Schiebetakt wie die Verzögerungsschaltungen 22 bis 26 und wirken somit ebenfalls als Signalverzögerung. Die Ausgänge von jeweils zwei dieser Register führen auf einen Addierer, d. h. die Ausgänge der Register 36 und 38 führen auf die Addierschaltung 44 und die Ausgänge der Register 40 und 42 auf die Addierschaltung 48. Deren Ausgänge führen wieder auf jeweils ein Register 46 bzw. 50, die das gleiche Taktsignal erhalten wie die Register 36 bis 42, so daß als Verarbeitungszeit für die Addierschaltungen 44 und 48 eine volle Taktphase zur Verfügung steht. Die Ausgänge der Register 46 und 50 führen auf eine weitere Addierschaltung 52, deren Ausgang wieder mit einem Register 54 verbunden ist, so daß für die Verarbeitungszeit der Addierschaltung 52 ebenfalls die vorstehende Aussage gilt. Der Ausgang des Registers 54 sowie des Multiplizierers 10 führen auf eine Addierschaltung 56, der das Register 60 nachgeschaltet ist, das hier für die Verarbeitung jedoch nicht unbedingt notwendig ist. Am Ausgang 59 erscheinen dann die gleichen Dualworte wie am Ausgang 19 der Schaltung nach Fig. 1, jedoch lediglich um zwei bzw. drei Taktzeiten verzögert. Der Summierer 20 nach Fig. 2 ist dabei in eine Anzahl Addierschaltungen aufgelöst, die zusammen mit den zwischengeschalteten Registern jedoch den Vorteil erbringen, daß die höchste Taktfrequenz der Taktsignale für die Register nur von der Verarbeitungszeit jeweils eines arithmetischen Elements, d. h. eines Multiplizierers bzw. eines Addierers, abhängt.

Auch die Multiplizierer 10 bis 18 können durch Addierschaltungen realisiert werden, die die Eingangswörter stellenverschoben addieren. Auf diese Weise sind dann für das Filter nur zwei verschiedene Schaltungen notwendig, nämlich Verzögerungsschaltungen in Form digitalen Registern sowie digitale Addierschaltungen.

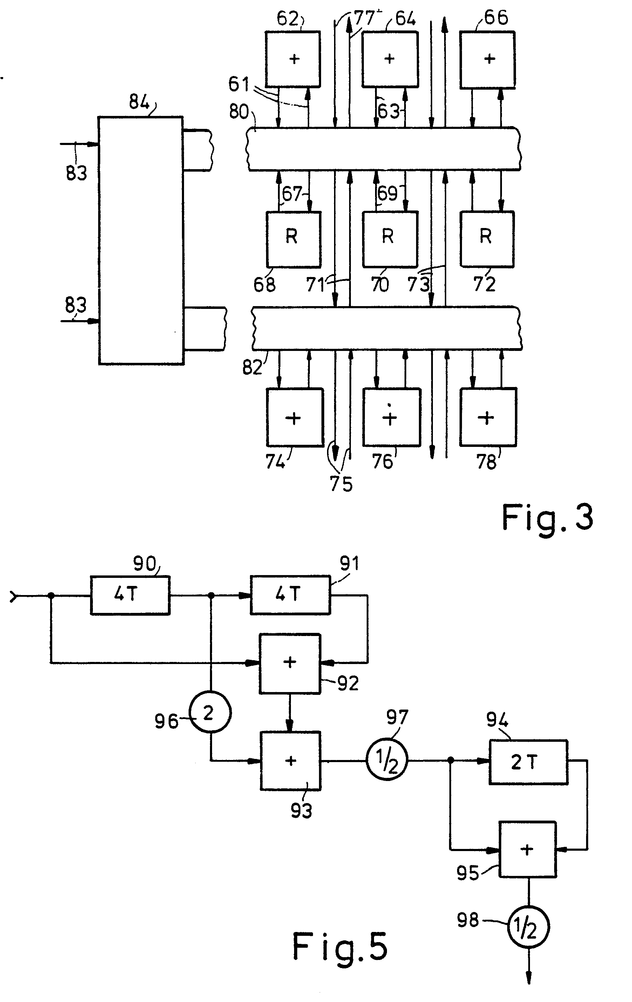

In Fig. 3 ist eine schematische Anordnung auf einem Ausschnitt eines Halbleiterplättchens dargestellt, auf dem eine Anzahl Addierschaltungen 62, 64, 66 und 74, 76 und 78 sowie eine Anzahl Verzögerungsschaltungen 68, 70 und 72 in einer regelmäßigen Struktur in Zeilen und Spalten angebracht sind. Im folgenden wird davon ausgegangen, daß jede Schaltung nur jeweils ein Bit verarbeitet, da dies eine flexiblere Anordnung der Verbindungen ermöglicht, wie später noch näher erläutert wird. Im vorliegenden Fall ist der Einfachheit halber nur eine kleine Anzahl von Addierschaltungen und Verzögerungsschaltungen dargestellt, während im praktischen Fall für größere Wortbreiten und komplexere Filterstrukturen tatsächlich eine wesentlich größere Anzahl solcher Schaltungen auf jeweils einem Halbleiterplättchen angebracht wird.

Die einzelnen Schaltungen sind mit jeweils einem Bereich 80 bzw. 82 über Verbindungsleiter 61, 63, 67 und 69 verbunden, wobei die Pfeilrichtung hier beispielsweise die Unterscheidung von Eingängen und Ausgängen andeuten möge.

Ferner sind noch Verbindungsleiter 71, 73, 75 und 77 vorhanden, die die Bereiche 80 und 82 sowie weitere entsprechende, nicht dargestellte Bereiche miteinander verbinden. Die erwähnten Addierschaltungen und Verzögerungsschaltungen sowie die Verbindungsleiter werden dabei fest angebracht, unabhängig von der gewünschten Filterstruktur.

Die gewünschte Filterstruktur wird in einem nachträglichen Herstellungsschritt erzeugt, bei dem zwischen bestimmten der Verbindungsleiter 61, 63, 67, 69 sowie 71, 73, 75 und 77 Verbindungen hergestellt werden, insbesondere durch Leiterbahnen, die in Richtung der Bereiche 80 bzw. 82 verlaufen. Dafür werden die Verbindungsleiter, die aus aufgedampften Metallbahnen oder aus Bahnen aus Polysilicium bestehen können, bei der Herstellung der regelmäßigen Struktur zunächst mit einer Isolierschicht, insbesondere mit $SiO_2$ bedeckt. Dies ist auch deswegen vorteilhaft, damit die so hergestellten Strukturen zunächst einfacher aufbewahrt werden können, ohne daß die Gefahr einer Verunreinigung der Überfläche besteht, bis die endgültige Filterstruktur im nachträglichen Herstellungsschritt festgelegt wird. In diesem nachträglichen Herstellungsschritt werden an einzelnen Stellen in der Isolierschicht über den Verbindungsleitern mit Hilfe einer Fotomaske in bekannter Weise Löcher geätzt, und danach wird mit Hilfe einer weiteren Maske ein definiertes Muster von Leiterbahnen, vorzugsweise aus Aluminium, aufgebracht. Für die Herstellung eines bestimmten Filters sind damit nur zwei individuelle Masken erforderlich.

Eine andere Möglichkeit, die Verbindungen im nachträglichen Verbindungsschritt herzustellen, besteht darin, daß bei der vorhergehenden Herstellung der regelmäßigen Struktur an zumindest einem Teil der Kreuzungsstellen der Verbindungsleiter und den in Richtung der Bereiche 80 bzw. 82 verlaufenden Leiterbahnen elektronische, elektrisch steuerbare Schalter angebracht werden. Diese Schalter können beispielsweise als Feldeffekt-Transistoren ausgebildet sein. Im nachträglichen Herstellungsschritt werden

**0 088 474**

dann außer den Leiterbahnen an den von den Verbindungsleitern abgewandten Enden der Schalter auch Leiterbahnen für die Steuereingänge oder Schalter angebracht. Da die Anzahl der Schalter selbst dann, wenn ein Teil der Verbindungen der Verbindungsleiter untereinander direkt durch Leiterbahnen gebildet werden, noch relativ groß ist, ist es allgemein nicht zweckmäßig, die Steuereingänge der Schalter mit einzelnen Leitungen von dem Halbleiterplättchen herauszuführen. Statt dessen werden die Leiterbahnen der Steuereingängen der Schalter mit einem Speicher 84 verbunden, der über die Eingänge 83 angesteuert bzw. adressiert wird. Dieser Speicher 84 kann so ausgebildet werden, daß er von außen mit Informationen gefüllt werden kann, allgemein wird es jedoch zweckmäßig sein, diesen Speicher 84 als Festwertspeicher auszubilden, so daß bei Ansteuerung einer bestimmten Adresse des Speichers eine bestimmte Kombination von Schaltern betätigt und damit ein Filter mit einer vorgegebenen Struktur entsprechend einer gewünschten Übertragungsfunktion erzeugt wird. In dem nachträglichen Herstellungsschritt können dann nicht nur die Verbindungen zwischen den Steuereingängen der Schalter und dem Speicher, sondern auch der Inhalt des Speichers 84 selbst hergestellt werden. Auf diese Weise kann in dem nachträglichen Herstellungsschritt aus einer regelmäßigen Struktur von Addierschaltungen und Verzögerungsschaltungen mit geringem Aufwand eine Vielzahl von verschiedenen Filtern erzeugt werden.

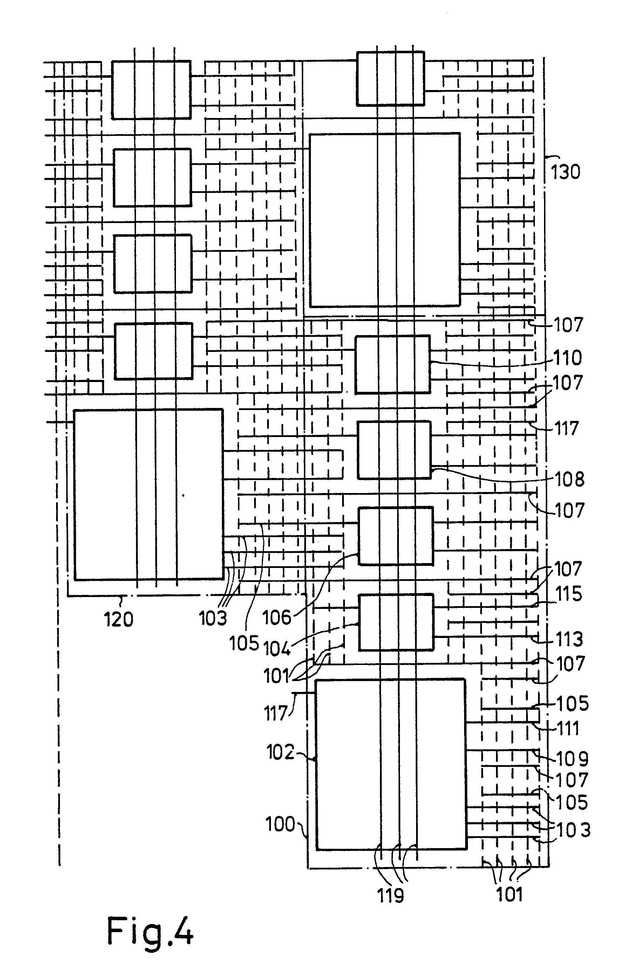

In Fig. 4 sind einige sogenannte Basiszellen 100, 120, 130 in ihrer Lage zueinander und für die Basiszelle 100 in ihrem internen Aufbau dargestellt. Die Basiszelle 100 enthält einen binären Volladdierer 102 für ein Bit mit drei Eingängen für die beiden Summanden und das Übertragssignal der vorhergehenden Bitstufe, die an die Verbindungsleiter 103 angeschlossen sind, einem Summenausgang, der an den Verbindungsleiter 109 angeschlossen ist, sowie mit zwei Übertragsausgängen, von denen der eine an den Verbindungsleiter 111 und der andere an den Verbindungsleiter 117 angeschlossen ist. Die doppelte Herausführung des Übertragsausgangs ist für die Herstellung der Verbindungen im nachträglichen Herstellungsschritt günstig, da der Verbindungsleiter 117 insbesondere bei den folgenden Basiszellen leicht mit einem Eingang einer links davon liegenden Basiszelle verbunden werden kann, die für die Verarbeitung der Bits der jeweils nächsthöheren Ordnung in den zugeführten Dualwörtern vorgesehen ist. Dies ist die normale Übertragsverarbeitung. Falls jedoch eine Multiplikation des Ausgangssignals des Addierers 102 mit dem Faktor 1/2 vorgenommen werden soll, muß das Summenausgangssignal auf dem Verbindungsleiter 109 in der folgenden Zeile weiter rechts, die nicht dargestellt ist, die jedoch ggf. für die Verarbeitung der Bits nächstniedrigerer Ordnung vorgesehen ist, weiterverarbeitet werden, während das Übertragsausgangssignal auf dem Verbindungsleiter 111 in der gleichen Zeile von Basiszellen weiterverarbeitet werden muß.

Ferner enthält die Basiszelle 100 vier Register 104, 106, 108 und 110 für jeweils ein Bit. Der Informationseingang der Register ist jeweils mit einem Verbindungsleiter 113 verbunden, während der Ausgang der Register wieder auf beiden Seiten mit je einem Verbindungsleiter 105 bzw. 115 verbunden ist. Auch hierdurch können leicht die Ausgangssignale in der gleichen oder in der nächsthöheren Zeile von Basiszellen verarbeitet werden.

Die Verbindung der Verbindungsleiter untereinander erfolgt durch Leiterbahnen, deren Plätze durch die gestrichelten Linien 101 angegeben sind. Das Bündel dieser Linien 101 stellt somit den Bereich 80 bzw. 82 der Fig. 3 dar. Zur Verbindung der möglichen Leiterbahnen auf den Linien 101 in verschiedenen Zeilen von Basiszellen dienen insbesondere die Verbindungsleiter 107, die sich sogar über drei Zeilen von Basiszellen erstrecken, wie erkennbar wird, wenn die regelmäßige Struktur der dargestellten Basiszellen an ihren Rändern fortgesetzt wird. Im übrigen erstrecken sich die Verbindungsleiter an Eingängen bzw. Ausgängen der Addierer und der Register zumindest teilweise in Bereiche benachbarter Zeilen von Basiszellen, die von den Linien 101 durchlaufen werden, so daß dort Verbindungen mit Leiterbahnen im nachträglichen Herstellungsschritt angebracht werden können. Die Verbindungsleiter 105 und 107 zwischen den Verbindungsleitern 103 und 109 gehen beispielsweise von der Basiszelle in der benachbarten Zeile, wie an der Verbindungsstelle der beiden Basiszellen 100 und 120 zu erkennen ist. Die Verbindung über die Leiterbahnen erfolgt dadurch, daß in die (nicht dargestellte) Isolierschicht, die über den Verbindungsleitern im vorhergehenden Herstellungsvorgang angebracht wurde, an der Kreuzungsstelle des gewünschten Verbindungsleiters und einer der Linien 101 eine Öffnung geätzt wird und danach die Leiterbahn aufgebracht wird.

Für die Zufuhr des Versorgungsstromes und der Taktsignale dienen die Leiterbahnen 119, die über die Addier- und Verzögerungsschaltungen verlaufen und zweckmäßig ebenfalls im nachträglichen Herstellungsschritt angebracht werden (wie oben beschrieben), wobei in Schaltungen, deren Verbindungsleiter keine Verbindung mit nachträglich angebrachten Leiterbahnen erhalten, für die Leiterbahnen 119 keine Öffnungen in die Isolierschicht geätzt werden, so daß diese Schaltungen auch keine Verlustleistung erzeugen können.

Der dargestellte Aufbau jeweils einer Basiszelle stellt nur eine Möglichkeit dar, insbesondere kann die Anzahl und die Verteilung dem Register bezüglich des Addierers anders gewählt weden, jedoch hat sich die dargestellte Anordnung mit den Möglichkeiten für Leiterbahnen auf beiden Seiten der Register als zweckmäßig erwiesen.

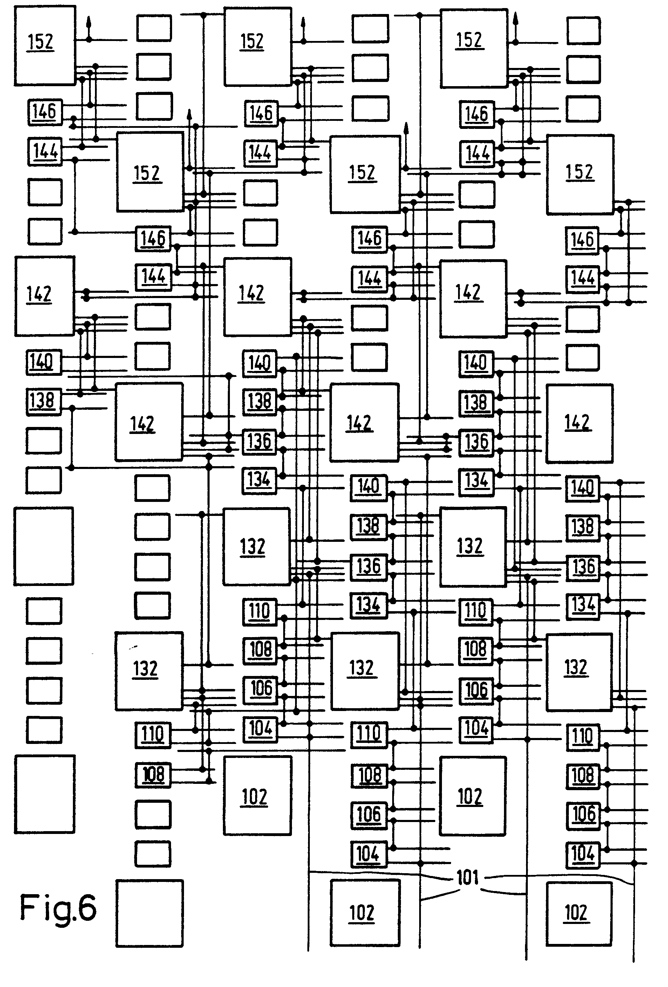

Ein Beispiel eines Verbindungsmusters mittels Leiterbahnen zur Verbindung der Verbindungsleiter der einzelnen Basiszellen für ein bestimmtes Filter wird nachstehend anhand der Fig. 6 erläutert, wobei die Struktur des dadurch gebildeten Filters in Fig. 5 angegeben ist. Die von außen bitparallel ankommenden Dualwörter werden einer Kette aus vier Registerstufen 90 zugeführt, die also eine Verzögerung um vier Schiebetaktzeiten bewirkt. Der Ausgang der Registerstufen 90 ist mit dem Eingang einer weiteren Kette von Registerstufen 91 verbunden, die ebenfalls vier Stufen enthält und somit eine weitere Verzögerung von vier Schiebetaktzeiten

5

bewirkt.

Der Eingang des Filters sowie der Ausgang der Registerkette 91 sind mit den Eingängen eines Addierers 92 für die Addition zweier Mehrbit-Dualworte verbunden. Bei einer beispielsweise angenommenen Anzahl von vier Bits für die Länge der Eingangsworte und damit auch der Ausgangsworte der Registerkette 91 treten am Ausgang des Addierers 92 durch das höchste Übertragssignal fünf Bit auf. In praktischen Fällen wird die Anzahl paralleler Bits allgemein höher gewählt.

Der Ausgang des Addierers 92 ist nun mit dem einen Eingang eines weiteren Addierers 93 verbunden, dessen anderer Eingang über einen Multiplizierer 96 die am Ausgang der Registerkette 90 auftretenden Dualwörter erhält. Der Multiplizierer 96 multipliziert die empfangenen Dualwörter mit dem Faktor 2, was einer Stellenverschiebung um ein Bit entspricht. Der Addierer 93 erzeugt nun Ausgangswörter mit sechs Bit, die einem weiteren Multiplizierer 97 zugeführt werden, der eine Multiplikation mit dem Faktor 1/2 durchführt. Dies entspricht einer Stellenverschiebung in entgegengesetzter Richtung, wobei das letzte Bit niedrigster Wertigkeit weggelassen wird.

Die dadurch entstehenden Dualworte mit fünf Bit werden nun einem weiteren Addierer 95 sowie einer Registerkette 94 aus zwei Registerstufen zugeführt, die somit eine Verzögerung um zwei Schiebetaktzeiten bewirkt. Der Ausgang dieser Registerkette 94 ist mit dem anderen Eingang des Addierers 95 verbunden, der wieder 6-Bit-Wörter am Ausgang erzeugt. Diese werden einem weiteren Multiplizierer 98 zugeführt, der wieder eine Multiplikation mit dem Faktor 1/2 durchführt, d. h. das Bit niedrigster Wertigkeit wird weggelassen, und das Ausgangssignal des Filters besteht damit aus Dualwörtern mit fünf Bit. Das Filter mit dem in Fig. 5 dargestellten Aufbau hat die Übertragungsfunktion

$$H(z) = \frac{1+2 \cdot z^1 + z^2}{2} \cdot \frac{1 + z^2}{2}$$

und stellt ein Tiefpaßfilter dar.

Der Aufbau des Filters nach Fig. 5 aus einzelnen Basiszelen für jeweils nur ein Bit gemäß Fig. 4 ist in Fig. 6 dargestellt.

Da maximal sechs Bit parallel auftreten können, sind in Fig. 6 sechs Zeilen von Basiszellen vorhanden, wobei die Grenzen zwischen den einzelnen Basiszellen nicht mehr kenntlich gemacht sind. Die vier Bits der dem Filter zugeführten Dualwörter werden den rechten vier Zeilen der Basiszellen zugeführt, wobei in der ersten Basiszelle jeder Zeile der Addierer nicht angeschlossen ist. Der Addierer 92 in Fig. 5 entspricht dem zweiten Addierer in den rechten vier Zeilen. In gleicher Weise entspricht die erste Kette 90 von Registerstufen jeweils den ersten vier Registern in den rechten vier Zeilen und die zweite Kette 91 von Registerstufen in Fig. 5 der zweiten Gruppe von vier Registern. Die beiden linken Zeilen werden verwendet für die Verarbeitung der Überträge bzw. der um ein Bit verschobenen Dualworte entsprechend der Multiplikation im Multiplizierer 96. Die Ausgangswörter des Filters werden den jeweils letzten in den Zeilen dargestellten Addierern entnommen, wobei der Addierer der rechten Zeile nicht angeschlossen ist, entsprechend der Multiplikation mit dem Faktor 1/2 im Multiplizierer 98 in Fig. 5. Der Übersichtlichkeit halber sind nur diejenigen Verbindungsleitungen und nur die an den den Linien 101 in Fig. 4 entsprechenden Stellen vorhandenen Leiterbahnen dargestellt, wobei Öffnungen in der Isolierschicht, an denen eine Verbindung zwischen Verbindungsleiter und Leiterbahn besteht, durch Punkte markiert sind. Die Leiterbahnen für die Stromversorgung und die Taktsignale entsprechend den Leiterbahnen 119 in Fig. 4 sind der Übersichtlichkeit halber nicht dargestellt.

**Patentansprüche**

1. Verfahren zur Herstellung einer digitalen Filteranordnung aus einer Anzahl Verzögerungsschaltungen, einer Anzahl Addierschaltungen und einer Anzahl durch Addierschaltungen realisierte Multiplikationsschaltungen als eine auf einem einzigen Halbleiterplättchen integrierte Schaltungsanordnung, bei dem die Verzögerungsschaltungen und die Addierschaltungen auf dem Halbleiterplättchen vorgesehen werden und nach Festlegung der Filtercharakteristik, insbesondere der Übertragungsfunktion, die einzelnen Verzögerungsschaltungen und Addierschaltungen entsprechend verbunden werden, dadurch gekennzeichnet, daß eine Anzahl Basiszellen, von denen jede aus einer Addierschaltung und einer Anzahl in einer Reihe damit angeordneten Verzögerungsschaltungen für jeweils ein Bit bestehen, von denen aus sich Verbindungsleiter parallel zueinander etwa senkrecht zur Reihe erstrecken, in Zeilen und Spalten angeordnet sind, wobei die Verzögerungsschaltungen und die Addierschaltungen zunächst ohne Verbindungen untereinander angebracht werden, und daß in einem nachträglichen Herstellungsschritt an den Verbindungsleitern Verbindungspunkte und in Zeilenrichtung verlaufende, die Verbindungsleitungen kreuzende und die Verbindungspunkte berührende Leiterbahnen angebracht werden.

2. Verfahren nach Anspruch 1, dadurch gekennzeichnet, daß ein Teil der Verbindungen durch ein gesondert angebrachtes Verbindungsmuster und die übrigen Verbindungen durch steuerbare Schalter gebildet werden.

3. Verfahren nach Anspruch 2, dadurch gekennzeichnet, daß Verbindungen zwischen den Steuereingängen der steuerbaren Schalter und einem auf dem Halbleiterplättchen vorhandenen binären Speicher angebracht werden.

4. Verfahren nach Anspruch 3,
dadurch gekennzeichnet, daß die Verbindungen für die Steuereingänge der steuerbaren Schalter ebenfalls im nachträglichen Herstellungsschritt angebracht werden.

5. Verfahren nach Anspruch 1 oder einem der folgenden,
dadurch gekennzeichnet, daß nur ein Teil der Schaltungen, insbesondere der Verzögerungsschaltungen, mit Verbindungen versehen werden.

6. Verfahren nach Anspruch 1 oder einem der folgenden,
dadurch gekennzeichnet, daß auch Verbindungen für die Stromversorgung der einzelnen Schaltungen in dem nachträglichen Herstellungsschritt hergestellt werden, wobei für Schaltungen ohne Signalverbindungen auch die Verbindungen für die Stromversorgung weggelassen werden.

7. Verfahren nach Anspruch 6,
dadurch gekennzeichnet, daß in benachbarten, in Richtung der Reihenanordnung in den Basiszellen verlaufenden Zeilen von Basiszellen diese um einen Teil der Länge der Basiszellen gegeneinander verschoben sind.

8. Verfahren nach Anspruch 7,
dadurch gekennzeichnet, daß in den Basiszellen die Verbindungsleitungen sich nach beiden Seiten der Schaltungen erstrecken und zwischen den Schaltungen jeder Basiszelle weitere, parallel zu den Verbindungsleitungen verlaufende Verbindungsleitungen angebracht sind und daß die angebrachten oder anbringbaren Leiterbahnen die Verbindungsleitungen auf beiden Seiten der Schaltungen kreuzen.

9. Verfahren nach Anspruch 7 oder 8,
dadurch gekennzeichnet, daß die Leiterbahnen sich über mehrere Basiszellen einer Zelle erstrecken.


## Claims

1. A method of manufacturing a digital filter comprising a plurality of delay circuits, a plurality of adder circuits and a plurality of multiplier circuits as an integrated circuit on a single semiconductor wafer, characterized in that the delay circuits and the adder circuits are provided on the semiconductor wafer and after the filter characteristics, more specifically the transfer function have been decided, the individual delay circuits and the adder circuits are connected in accordance therewith, characterized in that a plurality of basic cells, each of which is formed from an adder circuit and a plurality of delay circuits for always one bit, arranged in series therewith, from where connecting lines extend parallel to each other approximately perpendicularly to the series arrangement, are arranged in rows and columns, the delay circuits and the adder circuits first being provided without interconnections, and that in a subsequent manufacturing step connection points are provided at the connecting lines and conductor tracks which extend in the line direction intersect the connecting lines and contact the connection points.

2. A method as claimed in Claim 1, characterized in that a part of the connections are constituted by a separately formed connecting pattern and the other connections are constituted by controllable switches.

3. A method as claimed in Claim 2, characterized in that connections are formed between the control inputs of the controllable switches and a binary memory is present in the integrated circuit.

4. A method as claimed in Claim 3, characterized in that the connections for the control inputs of the controllable switches are also formed in the subsequent manufacturing step.

5. A method as claimed in Claim 1 or any of the claims subsequent thereto, characterized in that only some of the circuits, more specifically the delay circuits, are provided with connections.

6. A method as claimed in Claim 1 or any of the claims subsequent thereto, characterized in that power supply connections for the individual circuits are also formed in the subsequent manufacturing step, whilst for circuits without signal connections also the power supply connections are dispensed with.

7. A method as claimed in Claim 6, characterized in that in adjacent lines of basic cells extending in the direction of the series arrangement in the basic cells these lines are shifted through a part of the length of the basic cells.

8. A method as claimed in Claim 7, characterized in that in the basic cells the connecting lines extend to both sides of the circuits and between the circuits of each basic cell further connecting lines are provided parallel to the connecting lines and that the conductor tracks which have been or can be provided intersect the connecting lines at both sides of the circuits.

9. A method as claimed in Claim 7 or 8, characterized in that the conductor tracks extend over a plurality of basic cells of a cell.


## Revendications

1. Procédé pour fabriquer un montage de filtre numérique à partir d'un certain nombre de circuits à retard, d'un certain nombre de circuits additionneurs et d'un certain nombre de circuits multiplicateurs réalisés par des circuits additionneurs, sous forme d'un montage de circuit intégré sur une seule plaquette semi-conductrice, dans lequel les circuits à retard et les circuits additionneurs sont prévus sur la plaquette semi-conductrice et, après fixation de la caractéristique de filtrage, en particulier de la fonction de transmission, les circuits à retard et les circuits additionneurs individuels sont connectés de manière correspondante,

caractérisé en ce qu'un certain nombre de cellules de base, qui sont constituées chacune d'un circuit additionneur et d'un certain nombre de circuits à retard, chacun pour un bit, disposés dans une rangée avec le circuit additionneur, et desquelles partent des conducteurs de connexion s'étendant parallèlement l'un à l'autre et à peu près perpendiculairement à la rangée, sont disposées en lignes et colonnes, les circuits à retard et les circuits additionneurs étant initialement installés sans interconnexions, et qu'au au cours d'une étape de fabrication ultérieure, des points de connexion sont formés sur les conducteurs de connexion, et des dépôts conducteurs s'étendant dans la direction des lignes, croisant les conducteurs de connexion et entrant en contact avec les points de connexion, sont appliqués.

2. Procédé suivant la revendication 1, caractérisé en ce qu'une partie des connexions est formée par un motif de connexions appliqué séparément et les autres connexions sont formées par des commutateurs pouvant être commandés.

3. Procédé suivant la revendication 2, caractérisé en ce que des connexions sont prévues entre les entrées de commande des commutateurs pouvant être commandés et une mémoire binaire présente sur la plaquette semi-conductrice.

4. Procédé suivant la revendication 3, caractérisé en ce que les connexions pour les entrées de commande des commutateurs pouvant être commandés sont également appliquées lors de l'étape de fabrication ultérieure.

5. Procédé suivant la revendication 1 ou l'une quelconque des revendications suivantes, caractérisé en ce qu'une partie seulement des circuits, en particulier des cicuits à retard, est pourvue de connexions.

6. Procédé suivant la revendication 1 ou l'une quelconque des revendications suivantes, caractérisé en ce que des connexions pour l'alimentation de courant des circuits individuels sont également établies au cours de l'étape de fabrication ultérieure, auquel cas les connexions destinées à l'alimentation de courant sont également omises pour les circuits sans connexions pour les signaux.

7. Procédé suivant la revendication 6, caractérisé en ce que dans des lignes de cellules de base voisines qui s'étendent dans les cellules de base dans la direction de la rangée, celles-ci sont décalées l'une de l'autre d'une partie de la longueur des cellules de base.

8. Procédé suivant la revendication 7, caractérisé en ce que dans les cellules de base, les lignes de connexion s'étendent vers les deux côtés des circuits et entre les circuits de chaque cellule de base sont montées d'autres lignes de connexion s'étendant parallèlement aux lignes de connexion, et que les dépôts conducteurs appliqués ou pouvant être appliqués croisent les lignes de connexion des deux côtés des circuits.

9. Procédé suivant la revendication 7 ou 8, caractérisé en ce que les dépôts conducteurs s'étendent sur plusieurs cellules de base d'une ligne.

Fig.1

Fig.2

1

0 088 474

Fig. 3

Fig. 5

Fig.4

Fig.6